# FASCICULE DE BREVET EUROPEEN

(11) **EP 2 404 868 B1**
(45) Date de publication et mention de la délivrance du brevet: **28.08.2013**
(21) Numéro de dépôt: 11171866.4
(22) Date de dépôt: 29.06.2011
(51) Int. Cl.: B81C 1/00

(54) **Procédé de fabrication d'une structure fixe définissant un volume recevant un élément mobile notamment d'un MEMS**
Herstellungsverfahren einer festen Struktur eines bestimmten Volumens, in die ein mobiles Element, insbesondere ein MEMS, eingefügt werden soll
Method for manufacturing a stationary structure defining a space containing a mobile element, in particular of a MEMS

(30) Priorité: 05.07.2010 FR 1055434
(43) Date de publication de la demande: 11.01.2012
(73) Titulaire: COMMISSARIAT A L'ENERGIE ATOMIQUE ET AUX ENERGIES ALTERNATIVES, 75015 Paris (FR)
(72) Inventeur: Dieppedale, Christel, 38920 CROLLES (FR); Borel, Stephan, 38920 Crolles (FR); Reig, Bruno, 38430 MOIRANS (FR); Sibuet, Henri, 38500 LA BUISSE (FR)
(74) Mandataire: Le Tourneau, Augustin

(56) Documents cités:
- WO-A2-2004/016036
- US-A1- 2006 003 511
- US-A1- 2008 308 884
- US-A1- 2009 142 872
- SOUCHON F ET AL: "Dielectric Charging Sensitivity on MEMS Switches", SOLID-STATE SENSORS, ACTUATORS AND MICROSYSTEMS CONFERENCE, 2007. TRANSDUCERS 2007. INTERNATIONAL, IEEE, PISCATAWAY, NJ, USA, 10 juin 2007 (2007-06-10), pages 363-366, XP031216043, ISBN: 978-1-4244-0841-2

## Description

La présente invention concerne un procédé de fabrication d'une structure fixe de semi-conducteur définissant un volume, rentrant par exemple dans la conception d'un microsystème électromécanique, ci-après dénommé MEMS (pour *"Micro Electro-Mechanical Systems"*), incluant notamment les NEMS (pour *"Nano Electro-Mechanical Systems"*).

Le volume défini par cette structure fixe est notamment destiné à permettre le déplacement d'un élément mobile (ou mécaniquement déformable) du composant MEMS, l'élément mobile étant généralement rattaché ou "suspendu" à la structure fixe.

L'invention s'applique particulièrement bien à la fabrication de MEMS à membrane déformable, tels que des capteurs de pression à détection capacitive ou des commutateurs *(switch),* par exemple des commutateurs à contact ohmique et à activation électrostatique comme décrits dans la publication *"*DIELECTRIC CHARGING SENSITIVITY ON MEMS SVVITCHES", F. Souchon, PL. Charvet, C. Maeder-Pachurka, M. Audoin (2007).

Comme les circuits intégrés en microélectronique, des composants MEMS sont fabriqués sur une même plaque de silicium (ou *"wafer"*) par empilement de différentes couches minces de matériaux différents à partir du substrat de silicium. Par ailleurs, afin de définir une géométrie particulière, ces matériaux peuvent être recuits, polis, gravés partiellement (en utilisant la photolithographie) ou complètement comme c'est le cas des couches sacrificielles.

Un composant MEMS comprend généralement, comme structure fixe, une cavité formant le volume évoqué précédemment, et comprend des électrodes discontinues créant une topologie en surface du substrat.

La réalisation d'un MEMS doit prendre en compte les exigences d'un cahier des charges. Ces exigences comprennent par exemple, dans le cas d'un élément de type membrane : la tension d'actionnement et/ou l'amplitude de mouvement de la membrane, la fréquence de résonance, les propriétés mécaniques de la membrane, etc.

A partir de ce cahier des charges, un calcul dimensionnel de la membrane et de la structure fixe est effectué en fonction du matériau constitutif choisi. A l'aide de logiciels de calcul appropriés, on obtient par simulation, des distances fonctionnelles (ou *"gaps" -* distances séparant deux parties du MEMS et influant, selon qu'elle est trop grande ou trop petite, sur le fonctionnement du MEMS), telles que la longueur et la largeur de la membrane, la profondeur de la cavité, ou encore l'entrefer séparant deux électrodes d'un commutateur. Un grand nombre de ces distances fonctionnelles est directement défini par les dimensions verticales des éléments composant la cavité du MEMS, l'axe vertical se référant notamment à un axe perpendiculaire au plan de la membrane

Comme évoqué dans la publication US 5 919 548 ou EP 1 900 679, la fabrication d'un MEMS à élément suspendu comprend classiquement la gravure partielle d'un substrat de silicium pour former une cavité définissant le volume destiné à recevoir l'élément mobile dans ses déplacements, l'oxydation thermique du substrat ainsi gravé pour fournir une couche d'isolation électrique, la formation d'un premier niveau de MEMS (par exemple des contacts et pistes électriques constitutifs de la partie fixe du MEMS) dans la cavité sur la couche d'isolation électrique, le dépôt d'une couche sacrificielle dans la cavité pour recouvrir ce premier niveau, puis la formation d'un deuxième niveau du MEMS (l'élément mobile avec des contacts et/ou pistes électriques) sur la couche sacrificielle avant élimination de cette dernière pour libérer l'élément mobile.

Dans la publication *"DIELECTRIC CHARGING SENSITIVITY ON MEMS SWITCHES"* précitée, le procédé de fabrication d'un commutateur à contact ohmique et à activation électrostatique prévoit d'abord une oxydation thermique du substrat de silicium pour former une couche épaisse d'oxyde de silicium (généralement du dioxyde de silicium SiO₂ ou "silice" sur quelques micromètres, par exemple entre 5 et 10 µm) sur ce substrat.

Les techniques actuelles d'oxydation thermique sont suffisamment bien maîtrisées pour obtenir des couches SiO₂ d'épaisseur homogène sur l'ensemble du substrat ou localement, et pour choisir précisément cette épaisseur, allant de quelques couches atomiques à plusieurs dizaines de µm (micromètres).

Puis deux étapes de gravure réalisées successivement sur cette couche SiO₂ sont alors nécessaires pour obtenir deux distances verticales fonctionnelles créant respectivement la cavité définissant le volume et des plots destinés à supporter un contact électrique, une piste électrique ou encore une électrode.

Les gravures ne sont ici que partielles de sorte à conserver une épaisseur de SiO₂ en tout point de la structure, afin d'assurer une isolation électrique du substrat. De plus, en ne gravant que partiellement cette structure, des agents de gravure non sélectifs vis-à-vis du substrat Si (et donc plus nombreux) peuvent être utilisés.

La suite de la fabrication pour créer successivement le premier niveau de MEMS, la couche sacrificielle, le deuxième niveau de MEMS avec un contact électrique en regard de celui porté par un dit plot, et pour éliminer la couche sacrificielle demeure classique.

Comme évoqué précédemment, le contrôle des distances fonctionnelles joue un rôle clé dans le bon fonctionnement du MEMS.

A titre illustratif, la profondeur de la cavité doit être suffisante pour accepter l'amplitude de mouvement de l'élément mobile du MEMS. De même, l'entrefer séparant, dans un commutateur à contact ohmique et à activation électrostatique, l'électrode disposée sur la structure fixe du MEMS et l'électrode disposée en regard sur l'élément suspendu influe directement sur la tension d'actionnement permettant de commuter le commutateur. Dans ce dernier exemple, la connaissance précise de l'entrefer permettrait d'ajuster la tension d'actionnement.

Dans les différentes techniques connues de fabrication d'une structure fixe de semi-conducteur définissant un volume telles que décrite ci-dessus, l'ensemble des distances fonctionnelles est défini par les dimensions gravées dans le substrat ou la couche SiO₂. C'est en particulier vrai pour la profondeur du volume prévu pour recevoir le mouvement de l'élément mobile, et pour l'entrefer entre des contacts électriques ou électrodes du commutateur.

Bien qu'il existe des techniques, par exemple de masquage, qui permettent un contrôle précis de la gravure selon deux dimensions (en fait selon le plan du substrat), le contrôle de la profondeur de gravure s'avère excessivement délicat et donc potentiellement préjudiciable pour la production de MEMS.

En effet, d'une part, la profondeur de gravure dépend du temps d'exposition à l'agent de gravure, mais également d'autres paramètres rendant difficile la détermination du point exact de fin de gravure. Des gravures excessives ou insuffisantes susceptibles d'être dommageables pour le fonctionnement du composant MEMS peuvent alors se produire.

D'autre part, cette difficulté pour contrôler la profondeur de gravure restreint la reproductibilité de ces méthodes de fabrication. Cela limite la production de MEMS similaires en grand nombre.

Enfin, les mécanismes de gravure s'avèrent être inhomogènes en différents endroits d'une même plaque de silicium. Des observations montrent que des variations de profondeurs de gravure d'un ordre supérieur à 10% peuvent se produire sur une même plaque usinée. Une même plaque utilisée pour la fabrication d'un grand nombre de MEMS identiques peut ainsi produire des MEMS de qualités très variables, certains MEMS (généralement sur les bords de la plaque) pouvant se révéler être inexploitables. En outre, une marge d'erreur doit être appliquée sur les épaisseurs d'oxyde pour tenir compte de cette variation.

Dans le cas de la publication *"DIELECTRIC CHARGING SENSITIVITY ON MEMS SWITCHES",* ces défauts de précision, de reproductibilité et d'homogénéité sont en outre décuplés du fait de la mise en oeuvre de plusieurs gravures successives sur la même couche SiO₂.

Ces différentes techniques de fabrication produisent ainsi une quantité non négligeable de composants MEMS défectueux ou requièrent la prise en compte de marges d'erreur. Ces marges d'erreur peuvent notamment influer sur le mode de fonctionnement du composant MEMS (par exemple en devant augmenter des tensions d'actionnement, ce qui entraîne une surconsommation électrique).

La présente invention vise à pallier au moins l'un des inconvénients susmentionnés.

Il est également connu du document WO 2004/016036 la fabrication de transducteurs présentant une unique cavité, par mise en oeuvre d'une oxydation thermique d'un substrat suivie d'une gravure de la couche d'oxyde, et enfin d'une nouvelle oxydation pour former une couche d'isolation électrique.

Il est également connu du document US2006/003511 la fabrication d'un dispositif semi-conducteur à plusieurs grilles, au cours de laquelle une première grille est protégée par dépôt d'une couche d'oxyde, et les deux autres grilles sont formées par oxydation thermique, suivie d'une gravure et d'une nouvelle oxydation thermique.

Un contrôle de la hauteur de plusieurs éléments les uns par rapport aux autres est souhaité lors de la fabrication d'une structure à vocation d'être fermée, constituée de ces différents éléments.

Dans ce dessein, l'invention concerne notamment un procédé de fabrication d'une structure fixe (notamment de semi-conducteur) comme défini dans la revendication 1.

Cette structure fixe a notamment au moins deux éléments présentant respectivement au moins une dimension verticale distinct dans un volume défini par ladite structure fixe. Le procédé comprend une étape préalable de détermination d'au moins trois épaisseurs épaisseur en fonction des au moins deux dimensions verticales associées auxdits au moins deux éléments;
au moins deux étapes successives de formation, sur un substrat dont au moins une surface est en matériau thermiquement oxydable, des au moins deux éléments, chaque étape de formation comprenant:
- une étape d'oxydation thermique du substrat pour former, sur une portion nue de celui-ci, une couche d'oxyde sur une épaisseur égale à l'une des épaisseurs, et
- une étape de gravure, sélective par rapport audit matériau thermiquement oxydable, de la couche d'oxyde ainsi formée pour définir ledit volume dans une portion gravée de ladite couche par mise à nu du substrat sous-jacent et pour définir au moins un des éléments dans au moins une portion non gravée de ladite couche,
et une étape ultérieure d'oxydation thermique du substrat pour former, sur une portion nue de celui-ci, une couche d'oxyde sur une épaisseur égale à la troisième épaisseur, de sorte à obtenir les au moins deux éléments présentant les au moins deux dimensions verticales et formés uniquement par les oxydations successives du substrat..

Pour la mise en oeuvre de l'invention, le substrat peut être indifféremment un substrat homogène d'un matériau thermiquement oxydable, ou un substrat hétérogène dont au moins une des surfaces (généralement la partie supérieure) est en matériau thermiquement oxydable, tel que le Silicium ou le Germanium.

L'invention permet ainsi d'obtenir une cavité en oxyde, dont le substrat est isolé électriquement, pouvant intervenir dans la conception de MEMS.

Selon l'invention, la hauteur des éléments constitutifs de la structure fixe est définie à l'aide des oxydations thermiques successives. Cela résulte de la mise en oeuvre d'une gravure sélective par rapport au matériau du substrat qui supprime l'épaisseur entière d'oxyde au niveau de ladite portion gravée.

Une connaissance des mécanismes d'oxydation permet alors de connaître précisément la hauteur résultant du différentiel d'oxydation entre la portion non gravée subissant une nouvelle oxydation et la portion gravée sur laquelle le substrat à nu est à nouveau oxydé.

Comme, comparativement aux opérations de gravure classiques, les oxydations thermiques offrent un meilleur contrôle dans la formation des couches d'oxyde (épaisseur précise et couche régulière avec notamment des irrégularités nettement inférieures à 10%, voire même inférieures à 3%,.des distances fonctionnelles (liées aux dimensions verticales) plus précises peuvent être obtenues.

La connaissance des mécanismes d'oxydation permet ainsi de déterminer au préalable les épaisseurs à former lors de chaque oxydation thermique (ces oxydations venant se cumuler au niveau des zones non gravées pour former les éléments de la structure fixe) pour obtenir au final les dimensions verticales souhaitées.

Ainsi, la présente invention offre un contrôle accru des dimensions verticales (par rapport au plan défini par le substrat) produites lors de la fabrication d'une structure fixe. Ce contrôle accru est notamment obtenu par le fait que la topologie de la structure est désormais définie uniquement par des oxydations thermiques, lesquelles se révèlent être plus précises, reproductibles et homogènes que les opérations de gravure classiquement utilisées pour définir les gaps.

En particulier, par rapport aux techniques de l'état de l'art, la réalisation des éléments uniquement par des étapes successives d'oxydation thermique permet de contrôler la hauteur relative (ou altitude relative) de ceux-ci les uns par rapport aux autres au sein de la cavité.

On notera qu'outre les avantages résultant d'une maîtrise des distances fonctionnelles, l'invention permet également de réduire les marges d'erreur à appliquer lors de la fabrication.

On notera par ailleurs qu'une deuxième étape de formation interagit directement avec une étape précédente, puisque l'épaisseur d'oxyde définissant les éléments formés lors de la première étape se trouve accrue par l'oxydation thermique de la deuxième étape de formation.

Ainsi, les éléments de la structure fixe sont formés progressivement (ou itérativement) par l'addition de plusieurs couches d'oxyde. Cette formation progressive par addition d'épaisseurs s'avère nettement mieux contrôlée, facilement reproductible et plus homogène que la réalisation successive de gravure sur la même couche d'oxyde.

La mise en oeuvre d'étapes successives de formation par oxydation thermique permet ainsi de contrôler précisément deux dimensions verticales dans la structure fixe, et ainsi deux dimensions verticales fonctionnelles dans un MEMS résultant, par exemple la profondeur du volume et l'entrefer entre les contacts électrique du commutateur: chaque étape de formation permet donc d'introduire les bases d'une nouvelle distance fonctionnelle.

Bien entendu, l'invention n'est pas limitée à deux étapes de formation. Le nombre d'étapes de formation peut être égal au nombre de dimensions verticales différentes associées aux éléments à former, pour par exemple offrir un plus grand nombre de fonctions dans le MEMS résultant. Notamment le procédé peut comprendre trois étapes de formation d'éléments comme décrit par la suite.

Dans la présente invention, une portion non gravée lors d'une première étape de formation est une portion non gravée lors d'une étape ultérieure de formation. Cette disposition est en particulier applicable à toutes les portions non gravées lors de la première étape de formation.

Cette disposition permet d'accroître l'épaisseur de la couche d'oxyde au niveau de la portion non gravée lors de la première étape de formation, pour former progressivement les éléments de la structure fixe, en contrôlant l'incrément de l'épaisseur, l'homogénéité et la reproductibilité.

Dans la présente invention, lors d'une première étape de formation, ladite au moins une portion non gravée forme des parois définissant ledit volume. En définissant ledit volume de la cavité d'un MEMS par exemple, les parois définissent le repère dans l'appréciation des distances fonctionnelles. En effet, les éléments suspendus des MEMS (membranes déformables par exemple à partir desquels les distances fonctionnelles ont la plus grande importance) sont généralement fixés au sommet de ces parois comme il sera illustré par la suite.

Selon une caractéristique particulière, ladite première étape de formation forme une couche d'oxyde sur une première épaisseur E1 et la ou les étapes ultérieures de formation forment chacune une couche d'oxyde qui, sur une portion mise à nu du substrat, présente d'autres épaisseurs Ei, où i identifie une étape ultérieure de formation, de telle sorte que les parois définissant ledit volume ont, après les étapes ultérieures de formation, une épaisseur d'oxyde strictement comprise entre E1 et E1+ΣEi.

Selon une autre caractéristique particulière, lors d'une étape ultérieure de formation, une portion non gravée au niveau d'une portion entièrement gravée lors de l'étape de gravure immédiatement précédente forme au moins une butée. Cette butée peut constituer une butée pour un élément mécaniquement mobile de MEMS, par exemple une butée anti-collage pour une membrane déformable.

Selon une encore autre caractéristique particulière, lors d'une étape ultérieure de formation, une portion non gravée au niveau d'une portion entièrement gravée lors de l'étape de gravure immédiatement précédente forme au moins un plot pour recevoir un contact électrique. Ce plot doté *in fine* d'un contact électrique (incluant une piste électrique ou une électrode) a par exemple vocation à interagir avec un contact électrique supportée par un élément mobile de MEMS situé en regard de ce plot.

On peut par exemple créer successivement, dans cet ordre, les parois, des butées et un plot, ce qui est particulièrement adapté à la fabrication d'une structure fixe d'un commutateur MEMS.

Selon une caractéristique de l'invention, le procédé comprend une étape de nettoyage de la portion de substrat mise à nu, avant une oxydation thermique ultérieure, en particulier l'oxydation thermique dans une étape ultérieure de formation. Le nettoyage peut être mené à l'aide de solutions chimiques en milieu humide ou par recuit (par exemple sous vide).

Cette disposition permet d'obtenir, notamment dans le cas d'un substrat en silicium, un diélectrique ainsi qu'une interface Si/SiO₂ de très bonnes qualités, contribuant à un fonctionnement efficace de certains MEMS. C'est notamment le cas des commutateurs RF où la mauvaise qualité des interfaces Si/SiO₂ risque d'augmenter fortement les pertes de signal RF.

Selon une caractéristique particulière de l'invention, ladite gravure sélective met en oeuvre une gravure humide. On obtient ainsi une meilleure sélectivité vis-à-vis du matériau constituant le substrat (par exemple du silicium ou du germanium), ce qui offre un meilleur confort dans la gestion des étapes de formation car cette meilleure sélectivité requiert alors un contrôle réduit des phases de gravure.

En effet, la sélectivité de certains agents de gravure (tels l'acide fluorhydrique HF vis-à-vis du silicium) peut s'avérer être particulièrement forte en voie humide.

On notera toutefois qu'un contrôle réduit de la durée de gravure doit être opéré afin de limiter l'attaque latérale de la couche d'oxyde du fait du caractère isotrope de la gravure humide.

Dans un mode de réalisation, les étapes d'oxydation thermique du substrat sont effectuées à une température comprise entre 800°C et 1100°C. L'utilisation de hautes températures est particulièrement bien adaptée à la production rapide de couches d'oxyde d'épaisseur importantes au-delà du micromètre, notamment lorsqu'il s'agit d'un substrat de silicium.

Dans un mode de réalisation, la structure fixe est une structure fixe de microsystème électromécanique qui définit un volume apte à recevoir un élément mécaniquement mobile du microsystème électromécanique. La création de volumes dans des structures de semi-conducteurs trouve en effet une application très avantageuse dans la protection ou l'accueil des parties mobiles de MEMS.

Dans un mode de réalisation, ledit substrat est initialement plan avant la première étape de formation. Cette disposition permet un meilleur contrôle des paramètres relatifs aux épaisseurs des couches d'oxyde obtenues lors des oxydations thermiques. En effet, en présence d'irrégularités, l'oxydation thermique de la surface du substrat pourrait présenter de plus fortes inhomogénéités et donc présenter des épaisseurs d'oxyde moins précises.

Selon une caractéristique de l'invention, ladite étape préalable de détermination comprend l'évaluation desdites épaisseurs par simulation informatique. Compte tenu des performances de calcul actuelles, la simulation informatique permet d'obtenir des épaisseurs précises et donc des dimensions verticales (et les distances fonctionnelles associées) précises.

A titre d'exemple, le logiciel ATHENA de la société SILVACO (noms commerciaux) bien connu de l'homme de l'art permet de simuler des procédés d'oxydation thermique du silicium et peut donc être utilisé dans le cadre de la présente invention.

L'invention concerne également un procédé de fabrication d'un microsystème électromécanique (MEMS) comprenant les étapes suivantes:
- fabriquer une structure fixe de microsystème électromécanique comme décrit ci-dessus,
- former un élément mécaniquement mobile suspendu à ladite structure fixe et configuré pour se déplacer dans le volume défini par ladite structure fixe ainsi fabriquée.

Comme il sera vu par la suite, l'étape de formation d'un élément mécaniquement mobile peut comprendre les étapes suivantes:
- former une couche sacrificielle dans ledit volume défini par ladite structure fixe ainsi fabriquée,
- former, sur ladite couche sacrificielle, une couche apte à constituer une membrane mécaniquement déformable, et
- éliminer ladite couche sacrificielle de sorte à libérer ladite membrane.

Eventuellement, une étape d'aplanissement de la couche sacrificielle avant de former la membrane peut être menée. La création d'une topologie de circuit (contact, pistes électriques ou encore électrodes) est également prévue.

Dans un mode de réalisation, le procédé comprend, préalablement à l'étape de fabrication de l'élément mécaniquement mobile, une étape de dépôt d'une couche de protection sur ladite structure fixe.

Cette disposition permet notamment de prévenir d'éventuelles attaques de la structure fixe (de la couche SiO₂ formant les parois et les plots ou butées) par gravure, par exemple, lors de la formation de l'élément mécaniquement mobile. C'est notamment le cas lorsqu'une couche sacrificielle en oxyde de silicium déposé est utilisée car l'agent de gravure utilisé pour son élimination tendrait à attaquer également la structure fixe (notamment la couche d'isolation), en l'absence de cette couche de protection.

En particulier, ladite couche de protection comprend une espèce choisie parmi Si₃N₄, Si, Al et W. Cette disposition est particulièrement bien adaptée à prévenir une attaque par un agent de gravure dédié à la gravure d'un oxyde de silicium.

Selon un aspect de l'invention, ledit microsystème électromécanique est un commutateur, en particulier un commutateur à contact ohmique et à activation électrostatique.

D'autres particularités et avantages de l'invention apparaîtront encore dans la description ci-après, illustrée par les dessins ci-joints, dans lesquels :
- la **figure 1** illustre, sous forme de logigramme, des étapes générales d'un procédé de fabrication d'un MEMS mettant en oeuvre la présente invention;
- la **figure 2** illustre, sous forme de logigramme, l'étape de fabrication d'une structure fixe de MEMS lors du processus de la **figure 1****;**
- la **figure 3** illustre, sous forme schématique, l'évolution d'une structure fixe de MEMS lors des étapes de la **figure 2****;**
- la **figure 4** illustre, sous forme schématique, l'état d'une structure de MEMS lors de l'étape de formation d'un premier niveau de topologie électrique de la **figure 1****;**
- la **figure 5** illustre, sous forme de logigramme, l'étape de formation d'un deuxième niveau de topologie électrique lors la fabrication d'un MEMS conformément à la **figure 1****;** et
- la **figure 6** illustre, sous forme schématique, l'évolution de la structure de MEMS lors des étapes de la **figure 5****.**

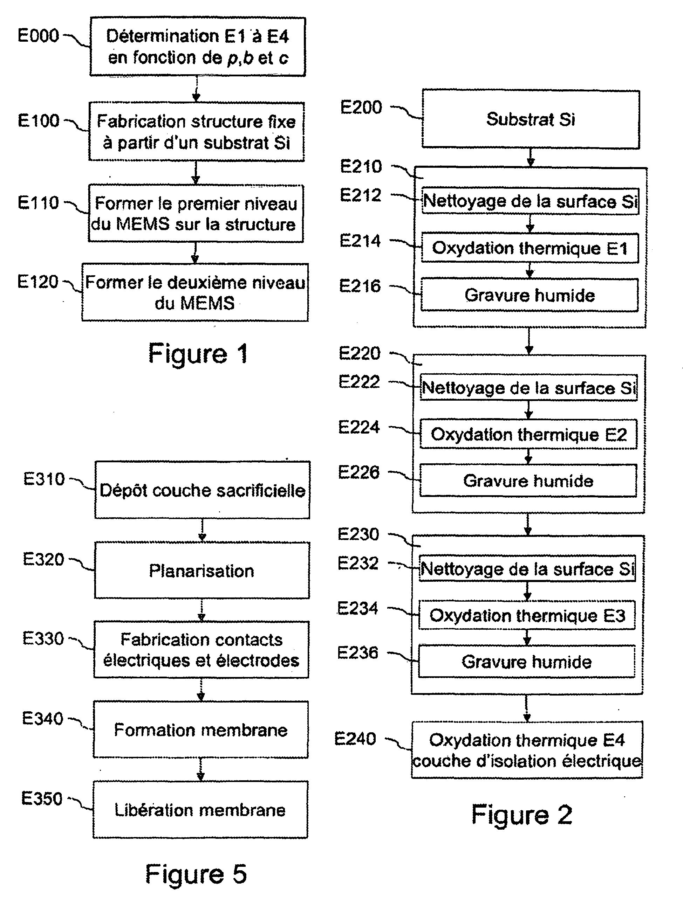

La **figure 1** illustre schématiquement des étapes générales pour la fabrication d'un MEMS à partir d'un substrat de silicium. Pour la suite de la description, on détaillera la fabrication d'un commutateur bien que l'invention puisse s'appliquer à d'autres types de MEMS et de structure de semi-conducteur. En outre, l'invention peut s'appliquer à d'autres natures de substrats, par exemple un substrat de germanium.

En outre, bien que l'on décrive ci-après la fabrication d'un MEMS 1, il est classique, en fait, de réaliser la fabrication d'un grand nombre de MEMS en même temps, tous portés sur une ou plusieurs plaques (ou tranche ou *"wafer"*) de silicium traitées en même temps.

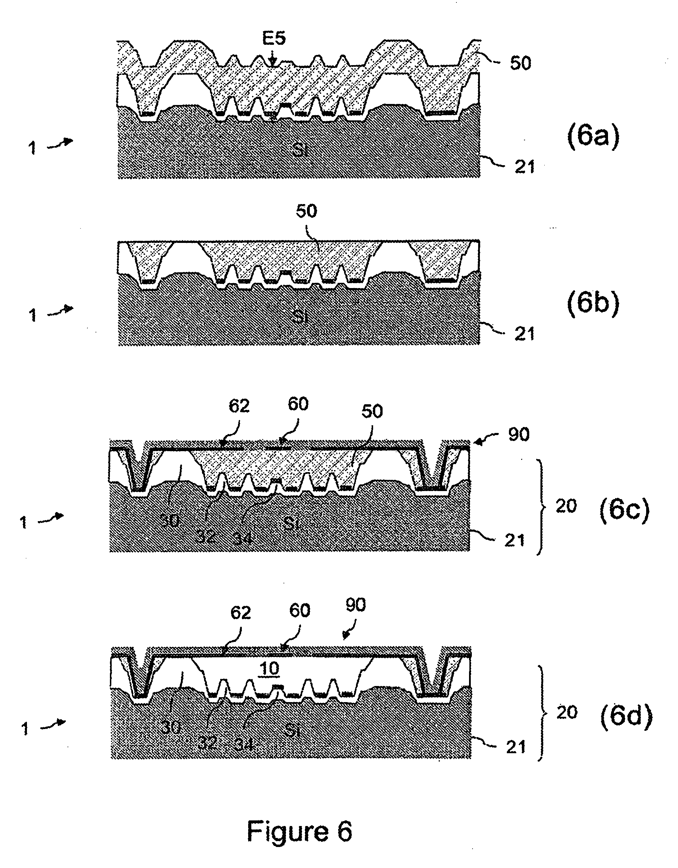

Comme représenté sur la **figure 6d****,** un MEMS 1 peut comprendre une cavité 10 formée dans une structure fixe 20 (première partie du MEMS) et définissant un volume dont les dimensions verticales offre une amplitude de mouvement à un élément mobile 90 (ici une membrane déformable) constituant la deuxième partie du MEMS 1.

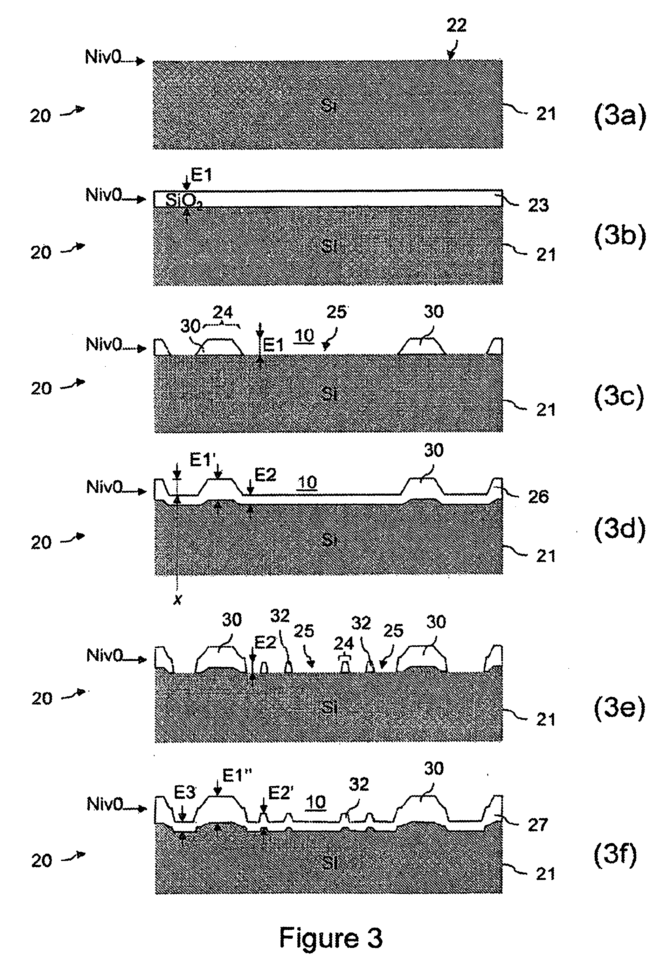

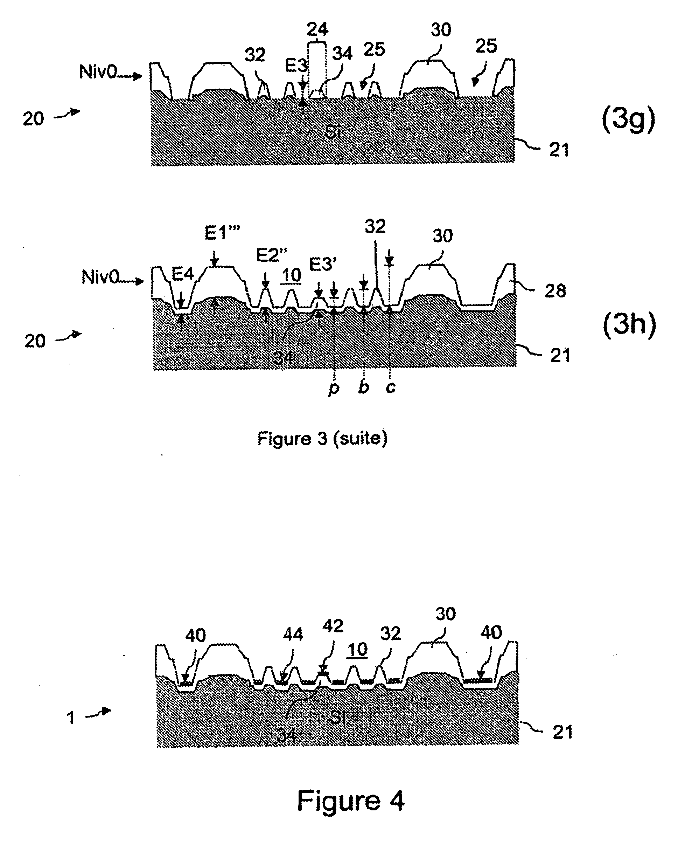

L'amplitude de mouvement de l'élément mobile 90 est notamment définie par des gaps fonctionnels définis entre différents éléments de la structure fixe. Dans un exemple de mise en oeuvre de l'invention, des gaps fonctionnels tels que l'entrefer, la distance de la membrane à des butées anti-collage ou la profondeur de la cavité dérivent directement des dimensions verticales p, b et c **(****figure 3h****),** respectivement d'un plot 34 comprenant un contact électrique, d'une butée 32 et des parois 30 de la cavité.

Lors d'une première étape E000, à partir des gaps fonctionnels souhaités et donc des dimensions verticales p, b et c souhaitées, d'épaisseurs Ei (E1 à E4 dans l'exemple ci-après) sont déterminées. Comme il ressortira de la suite, ces épaisseurs sont utilisées lors d'oxydations successives d'un substrat 21 pour former progressivement et de façon itérative les différentes éléments constitutifs de la cavité, par exemple les parois 30, la butée 32 et le plot 34.

Cette détermination peut notamment être réalisée par simulation informatique d'oxydations thermiques d'un substrat 21 pour connaître précisément l'influence des conditions d'oxydation et la présence de couches d'oxyde sur l'oxydation du substrat sous-jacent à ces couches par rapport à l'oxydation de ce même substrat mis à nu.

A titre illustratif, partant des dimensions verticales souhaitées suivantes:
- hauteur c des parois 30 = 3,2 µm
- hauteur b des butées 32 = 2,2 µm
- hauteur p du plot 34 = 0.9 µm.
   une simulation informatique permet de déterminer les épaisseurs suivantes:
- E1=1,7 µm,
- E2=2 µm,
- E3=1,3 µm, et
- E4=2 µm.

Connaissant ces épaisseurs Ei, la structure fixe 20 comprenant la cavité 10 est fabriquée à partir d'un substrat de silicium 21 lors d'une étape E100.

Selon l'invention et comme décrit par la suite, cette étape E100 comprend au moins deux étapes de formation d'au moins deux éléments (par exemple une paroi 30, une butée 32 ou un plot 34) de ladite structure fixe 20 sur un substrat 21 par exemple de silicium, l'étape de formation comprenant une étape d'oxydation thermique du substrat pour former, sur une portion nue de celui-ci, une couche d'oxyde sur une épaisseur égale à une première épaisseur déterminée à l'étape E000, et une étape de gravure, sélective par rapport audit matériau thermiquement oxydable, de la couche d'oxyde ainsi formée pour définir ledit volume dans une portion gravée de ladite couche par mise à nu du substrat sous-jacent et pour définir l'élément dans au moins une portion non gravée de ladite couche,

Différentes réalisations de cette étape E100 sont décrites par la suite en référence à la **figure 2****.**

Pour former un MEMS 1, l'étape E100 est suivie d'une étape E110 de formation d'un premier niveau de topologie électrique du MEMS. Il s'agit principalement de la création de contacts électriques, pistes électriques ou autres électrodes 40/42/44 sur la structure fixe 20 créée à l'étape E100.

Des techniques classiques de dépôt de matériau, de photolithographie et de gravure peuvent être mise en oeuvre pour former ce premier niveau sur chaque structure formée dans une même plaque de silicium.

Dans le procédé de fabrication d'un commutateur détaillé ci-après, on dépose une couche mince d'or (Au) par dépôt physique en phase vapeur PVD (pour *"physical vapor deposition")* sur une épaisseur d'environ 1 µm puis une couche mince d'un matériau de contact (par exemple du Ruthénium ou un autre élément de la période 5 du tableau périodique des éléments), également par PVD, sur 0,1 µm.

La formation du premier niveau de topologie E110 est suivie de la formation de la membrane déformable 90 du MEMS et d'un deuxième niveau de topologie supporté par cette membrane déformable. Cette étape est référencée E120 et détaillée par la suite en référence à la **figure 5****.**

En référence maintenant à la **figure 2****,** on décrit plus en détails l'étape E100 de fabrication de la structure fixe 20 de MEMS 1.

A l'étape E200, on dispose d'un substrat classique de silicium 21. La surface supérieure 22 de celui-ci peut notamment avoir été préparée: par exemple aplanissement selon des techniques classiques.

La **figure 3a** illustre, en coupe, l'état de la structure 20 à cet instant.

La fabrication de la structure fixe 20 se poursuit par la réalisation de plusieurs étapes de formation d'éléments, tels que des parois 30 de la cavité 10, des butées 32 ou des plots 34 à vocation de plots de contacts.

Dans l'exemple de la **figure 2****,** trois étapes de formation E210, E220 et E230 ont été prévues pour définir trois distances verticales fonctionnelles (liées à p, b et c) dans la structure fixe 20 comme cela ressortira de la suite de la description.

Bien entendu, un plus grand nombre d'étapes de formation peut être prévu pour accroître par exemple le nombre de distances fonctionnelles selon le cahier des charges du MEMS à fabriquer.

Egalement, selon différents modes de réalisation, deux étapes de formation peuvent être prévues: par exemple l'étape E210 seule pour former une seule cavité, les étapes E210 et E220 pour former une cavité dotée de butées ou les étapes E210 et E230 pour former une cavité dotée d'un plot.

Dans ces différentes approches, les éléments composant la structure fixe sont créés progressivement par consommation du substrat de silicium 21 comme il ressortira de la suite. On veillera donc à définir, à l'aide des étapes de formation, les éléments depuis celui présentant, au final, la plus grande hauteur jusqu'à celui de plus petite dimension verticale.

Chaque étape de formation suit un même processus: une première étape optionnelle de nettoyage E212/E222/E232 des surfaces nues du substrat de silicium 21; une étape d'oxydation thermique E214/E224/E234 de la structure 20 formant ainsi une couche de SiO₂ d'épaisseur Ei (i étant le numéro d'itération de l'étape de formation) sur les surfaces nues du substrat 21 et épaississant cette même couche là où elle est déjà présente par consommation du substrat; et une étape de gravure humide E216/E226/E236 de cette couche de SiO₂ pour former une partie de la cavité 10 et des éléments 30/32/34.

Comme indiqué précédemment, c'est cette étape de gravure humide E216/E226/E236 qui s'avère être sélective par rapport au silicium de sorte à mettre à nu ledit substrat de silicium 21 au niveau des portions gravées.

Lors de la première étape de formation E210, on procède au nettoyage de la surface supérieure 22 du substrat 21 pour y éliminer les impuretés telles que des composés organiques, carbonés, métalliques ou de résine. Cela permet d'obtenir des interfaces Si/SiO₂ après oxydation (détaillée par la suite) de bien meilleure qualité.

A titre illustratif, ce nettoyage peut consister en un bain des plaques de silicium dans une solution chimique (voie humide). En variante, une opération de recuit de ces plaques sous vide ou sous atmosphère contrôlée peut être réalisée.

Une fois le substrat 21 nettoyé, on lui applique une oxydation thermique E214 de sorte à obtenir une couche mince 23 d'oxyde thermique, notamment de SiO₂ **(****figure 3b****).** Sur les **figures 3b à 3h**, seule une oxydation face avant est représentée, alors que le reste de la structure fixe 20 est susceptible d'être également oxydée si elle n'est pas protégée.

En particulier, cette oxydation thermique est réalisée à haute température comprise entre 800°C et 1100°C afin d'obtenir l'épaisseur E1 déterminée à l'étape E000 (généralement entre 1 et 4 µm) dans un temps satisfaisant pour des contraintes de production industrielle. Les techniques classiques d'oxydation thermique permettent d'obtenir une épaisseur E1 de la couche d'oxyde thermique 23 qui est relativement constante et homogène sur une partie nue 22 du substrat 21.

L'étape d'oxydation thermique E214 est suivie d'une étape de gravure de la couche de SiO₂ ainsi obtenue afin de former des éléments de la structure fixe 20, ici pour former les parois 30 de la cavité 10 **(****figure 3c** montrant schématiquement la structure 20 ― les proportions n'ayant pas été respectées pour les besoins d'illustration).

Pour la mise en oeuvre de l'invention, cette gravure est conduite pour éliminer l'entièreté de l'épaisseur E1 dans les zones à graver 24. Pour cela, on utilise des agents de gravure fortement sélectifs par rapport au silicium, par exemple l'acide fluorhydrique HF ou des mélanges à base d'HF.

En outre, la gravure est de préférence réalisée par voie humide, car de meilleures sélectivités par rapport au silicium peuvent être obtenues. Dans une variante, une gravure par voie sèche peut être envisagée avec les mêmes effets.

Cette gravure sélective permet de mettre à nu le substrat de silicium 21 au niveau des portions non gravées 25, sans pour autant attaquer le substrat. Seule une partie du substrat a été consommée lors de l'oxydation thermique E214. De préférence, on utilise des agents totalement ou quasi-totalement sélectifs vis-à-vis du silicium, de sorte à ne pas l'attaquer.

On obtient ainsi, à ce stade, des parois 30 dont la hauteur est parfaitement contrôlée, ici égale à E1.

Suite à l'étape E210, l'étape E220 permet de former des butées 32 dans la structure fixe 21.

Dans le cadre d'un MEMS de type commutateur illustré ici, ces butées ont pour fonction principale d'empêcher le collage de la membrane 90 sur le fond de la cavité, en assurant la présence d'air sous la membrane.

De façon similaire à l'étape E210, elle comprend une étape de nettoyage E222 des surfaces nues 25 du substrat 20, pour garantir une meilleure oxydation thermique, puis une étape d'oxydation thermique E224 de la structure 20 (sensiblement celle de la figure 3c), et enfin une étape de gravure E226.

L'oxydation thermique E224 est mise en oeuvre de façon similaire à l'étape E214 pour obtenir une couche 26 de SiO₂ d'épaisseur E2 au niveau des surfaces nues 25 du substrat. En contrôlant l'oxydation thermique, on obtient une épaisseur sensiblement égale à l'épaisseur E2 déterminée à l'étape E000. Généralement, E2 sera comprise entre 1 et 4 µm.

Comme on peut le constater sur la **figure 3d** représentant la structure après cette étape, l'épaisseur E1' d'oxyde thermique au niveau des parois 30 a également cru, mais d'une épaisseur supplémentaire inférieure à E2: E1 < E1' < E1 +E2. En effet, la présence des éléments 30 a ralenti l'oxydation thermique à ces endroits (temps de propagation de l'oxygène dans la couche 23 restée sur les zones non gravées).

L'oxydation thermique consommant le silicium du substrat 21, ce ralentissement de l'oxydation thermique implique une consommation moindre du silicium au niveau des parois 30, comme montré schématiquement sur la **figure 3d****.**

Rappelons enfin que cette consommation tend à faire "baisser" le niveau de l'interface Si/SiO₂ et que l'oxydation crée un plus grand volume d'oxyde thermique par rapport au silicium consommé de telle sorte que l'oxyde tend à "monter" par rapport au niveau initial (représenté par la flèche *Niv0* sur les figures - pour une épaisseur e de silicium consommé, l'interface Si/SiO₂ "baisse" de e, tandis que la surface supérieure de la couche créée "monte" d'un peu plus de e).

Des expérimentations et/ou simulations permettent notamment de connaître, en fonction de la largeur des éléments 30 et des paramètres d'oxydation thermique (durée, température), l'épaisseur supplémentaire (E1'-E1) obtenue ainsi que la "consommation moindre" sous les parois 30. Cela permet de déterminer précisément E1 et E2 au cours de l'étape E000, pour obtenir une épaisseur E1' ou une hauteur x précise.

La structure 20 de la figure 3d est alors gravée (E226) de façon similaire à l'étape E216 en conservant non gravées les portions non gravées (ici les parois 30) de l'étape E21 0 précédente.

Cette gravure, encore fortement sélectivement par rapport au silicium, permet de mettre à nu le substrat 21 au niveau de zones non gravées 25, et de former de nouveaux éléments de la structure 20, ici des butées 32 sur une épaisseur E2 (figure 3e)

L'étape de formation E230 est similaire à l'étape E220 avec une étape optionnelle de nettoyage E232, une oxydation thermique E234 et une gravure E236.

Lors de cette étape E230, la gravure E236 permet de former de nouveaux éléments dans la structure fixe 20, ici représentés par un plot 34 destiné à recevoir un contact électrique lors de la formation E110 du premier niveau de MEMS.

La **figure 3f** illustre la structure 20 obtenue après l'oxydation thermique E234 formant une couche 27 d'oxyde thermique ayant l'épaisseur E3 déterminée (généralement comprise entre 1 et 4 µm) au niveau des zones non gravées 25 et des épaisseurs augmentées au niveau des parois 30 et butées 32, avec:
E1 < E1" < E1+E2+E3; et
E2 < E2' < E2+E3.

Comme évoqué précédemment, les techniques de simulation permettent de déterminer précisément E1, E2 et E3 au cours de l'étape E000, en fonction de dimensions souhaitées (E1", E2' et/ou les hauteurs des parois/butées dans la cavité 10)

La **figure 3g** illustre la structure 20 obtenue après la gravure sélective E236. Un plot 34 d'épaisseur E3 a ainsi été formé.

Ces trois étapes de formation E210-E220-E230 permettent de créer petit à petit différents éléments de la structure fixe 20, définissant chacun une distance verticale fonctionnelle.

Comme à chaque étape, on grave l'entièreté de l'épaisseur de SiO₂ au niveau des zones gravées 25, ces distances fonctionnelles sont ici définies par les étapes d'oxydation thermique et non pas les étapes de gravure. Il en résulte un contrôle plus précis de ces distances fonctionnelles, quant à leur valeur, à leur reproductibilité dans le temps et à leur homogénéité dans une même plaque usinée ou de plaque à plaque.

Suite aux étapes de formation E210-E220-E230 (le nombre pouvant varier selon les modes de réalisation de l'invention), l'étape E240 consiste à former une couche d'isolation électrique du substrat 21. Cela vise en particulier les zones gravées 25, puisque les éléments 30, 32, 34 en oxyde thermique offrent déjà une isolation électrique pour les zones non gravées.

Cette étape E240 peut notamment être réalisée par une nouvelle oxydation thermique (similaire aux oxydations décrites ci avant) de la structure 20, permettant de former une couche 28 d'oxyde thermique SiO₂ **(****figure 3h****)** ayant l'épaisseur E4 déterminée (généralement comprise entre 1 et 4 µm) au niveau des zones 25. De façon optionnelle, un nettoyage préalable des zones de substrat 21 à nu peut également être opéré juste avant l'étape E240.

On obtient ainsi une cavité MEMS en oxyde, présentant une bonne isolation électrique.

Ainsi, les parois 30 présentent une épaisseur E1"' comprise entre E1 et E1+E2+E3+E4; les butées 32 présentent une épaisseur E2" comprise entre E2 et E2+E3+E4; le plot 34 présente une épaisseur E3' comprise entre E3 et E3+E4.

Encore une fois, E1, E2, E3 et E4 ont été déterminés précisément au cours de l'étape E100, en fonction de valeurs c, *b, p* et E4 (ou E1''', E2", E3' et E4) souhaitées.

A titre illustratif, dans les conditions de l'exemple évoqué précédemment, on obtient notamment une dimension verticale E1''' valant 3,7 µm.

Comme il ressort de ces explications, en permettant de définir les distances fonctionnelles (gaps) au travers des étapes additives (oxydation thermique) plus précises que les étapes de suppression (gravure), l'invention offre un contrôle précis d'un ensemble d'épaisseurs aussi bien sur leurs valeurs, que sur leur homogénéité au sein d'une même plaque et sur leur reproductibilité.

La figure 4 illustre l'étape E110 de formation du premier niveau de MEMS 1. Lors de cette étape des pistes électriques 40, des contacts électriques inférieurs 42 (notamment sur le plot 34) et/ou des électrodes 44 sont formés sur la surface inférieure de la cavité 90.

Toutefois de façon optionnelle, il peut être prévu une étape de dépôt d'une couche de protection sur la couche d'oxyde de silicium 28 obtenue à l'issue de l'étape E100.

Cette couche de protection a pour vocation de protéger la couche d'oxyde de silicium 28 (et donc le caisson de la cavité 90 et les éléments 30, 32, 34 en SiO₂ d'éventuelles gravures ultérieures, notamment de la gravure E350 utilisée ci-après pour éliminer la couche sacrificielle.

Par conséquent, la nature de cette couche de protection et la présence même de cette étape optionnelle sont fonction des agents de gravure utilisés lors de ces gravures ultérieures, et donc possiblement de la nature de la couche sacrificielle utilisée ci-après.

Par exemple, si la couche sacrificielle utilisée est en oxyde de silicium, on pourra utiliser une couche de protection faite d'un matériau choisi parmi le nitrure de silicium Si₃N₄, le silicium Si, l'aluminium Al et le tungstène W.

La **figure 5** illustre l'étape E120 visant à la formation de la membrane déformable 90 et du deuxième niveau de topologie électrique porté par cette membrane. L'étape E120 part du MEMS 1 dans l'état de la **figure 4**.

Une première étape E310 consiste à déposer une couche sacrificielle 50, par exemple en silicium Si par dépôt chimique en phase vapeur assisté par plasma (ou PECVD pour *"Plasma-enhanced chemical vapor deposition")* sur une épaisseur supérieure ou égale à la hauteur c de la cavité, par exemple sur E5=3,4 µm pour c=3,2 µm (voir **figure 6a****).**

D'autres matériaux peuvent toutefois être utilisés pour former tout ou partie de la couche sacrificielle, par exemple un oxyde de silicium (tel SiO₂), une résine, du molybdène, du tungstène, etc.

A l'étape E320, on aplanit la surface supérieure de la couche sacrificielle 50, par exemple par utilisation d'un procédé mécano-chimique (ou CMP pour *"chemical-mechanical planarization")* (figure 6b). Grâce au contrôle précis de ce procédé, on ajuste la surface supérieure à la même hauteur que le haut des parois 30.

Cette étape contribue également à un contrôle précis des distances fonctionnelles, car la surface supérieure résultante délimitera la position de la membrane déformable 90 en position de repos, comme il découle de la suite.

A l'étape E330, on fabrique, sur cette couche sacrificielle 50, les éléments de topologie électrique constituant le deuxième niveau du MEMS 1.

Pour un commutateur, il s'agit notamment de déposer un contact électrique supérieur 60 au regard du contact inférieur 42 porté par le plot 34 et éventuellement des pistes électriques. La paire de contacts 60-42 intervient notamment dans l'excitation et/ou dans la détection opérée lors du fonctionnement du MEMS 1. Les mêmes techniques que celles utilisées à l'étape E110 peuvent être mises en oeuvre.

Par ailleurs, des vias peuvent être pratiqués, par gravure dans la couche sacrificielle 50, au regard de pistes 40 ou de contacts inférieurs 42 pour permettre une connexion électrique entre les premier et deuxième niveaux de topologie électrique dans le MEMS 1.

Des électrodes 62 sont également formées sur la couche sacrificielle 50, par dépôt, photolithographie et gravure pour une plaque entière de silicium. Ces électrodes seront utilisées en combinaison avec les électrodes inférieures 44 pour notamment actionner le commutateur lors de l'application d'une tension d'actionnement entre elles. Par exemple, on peut utiliser un dépôt par PVD de nitrure de titane TiN sur une épaisseur d'environ 0,1 µm.

A l'étape E340, on forme la membrane déformable 90 sur chaque MEMS d'une plaque, par dépôt, photolithographie et gravure pour une plaque entière de silicium. Par exemple, on peut utiliser de nitrure de silicium SiN déposé par PECVD sur environ 1 µm d'épaisseur.

La figure 6c représente le MEMS à ce stade, la cavité 10 étant remplie par la couche sacrificielle 50.

A l'étape suivante E350, on libère la membrane 90 ainsi formée par élimination de la couche sacrificielle 50 (figure 6d). Cette élimination peut être mise en oeuvre par des techniques classiques de gravure sèche isotrope du silicium (lorsque la couche sacrificielle est en silicium).

On obtient ainsi un MEMS 1 dont les distances fonctionnelles sont celles indiquées précédemment et définies uniquement par les opérations additives (oxydation thermique et éventuels autres dépôts).

Pour un MEMS de type commutateur, l'invention permet une amélioration notable de son fonctionnement, en particulier :
- une réduction des pertes de signaux car le contrôle de l'interface Si/SiO₂ est de très bonne qualité, eu égard notamment aux nettoyages récurrents des surfaces mises à nu du substrat;
- un bon contrôle de la tension d'actionnement en raison de la précision, de l'homogénéité et de la reproductibilité du gap fonctionnel entre les électrodes 44 et 62 du MEMS;
- un bon contrôle de la résistance (ou force) de contact entre les contacts 60 et 42 supporté par le plot 34, en raison également de la précision, de l'homogénéité et de la reproductibilité du gap fonctionnel entre les contacts inférieurs 42 et supérieurs 60 du MEMS.

Les exemples qui précèdent ne sont que des modes de réalisation de l'invention qui ne s'y limite pas.

Par exemple, des dépôts de couches intermédiaires peuvent être prévus entre les différentes étapes de formation E210-E220-E230, par exemple en faisant croître d'autres matériaux sur les parois 30 ou les butées 32. Dans ce cas, on veillera toutefois à utiliser des agents de gravure qui sont également sélectifs à l'égard de ces autres matériaux afin de ne pas les attaquer, ou alors on veillera à protéger ces couches intermédiaires.

## Revendications

1. Procédé de fabrication d'une structure fixe (20) ayant au moins deux éléments (30, 32, 34), dont un élément forme des parois de la structure fixe, présentant respectivement au moins une dimension verticale distincte (p, b, c) dans un volume (10) défini par lesdites parois de ladite structure fixe, **caractérisé en ce qu'**il comprend:
une étape préalable de détermination (E000) d'au moins trois épaisseurs en fonction des au moins deux dimensions verticales associées auxdits au moins deux éléments dont les parois;
au moins deux étapes successives de formation (E210, E220, E230), sur un substrat (21) dont au moins une surface est en matériau thermiquement oxydable, des au moins deux éléments (30, 32, 34) dont les parois, chaque étape de formation (E210, E220, E230) dont la première forme les parois comprenant:
- une étape d'oxydation thermique (E214, E224, E234) du substrat (21) incluant les portions non gravées et les portions gravées lors de l'étape de formation précédente, pour former, sur une portion nue de celui-ci, une couche (23, 26, 27) d'oxyde sur une épaisseur égale à l'une (E1, E2, E3) des épaisseurs, et
- une étape de gravure (E216, E226, E236), sélective par rapport audit matériau thermiquement oxydable et conservant non gravées les portions non gravées lors de l'étape de formation précédente, de la couche (23, 26, 27) d'oxyde ainsi formée pour définir ledit volume (10) dans une portion gravée (25) de ladite couche par mise à nu du substrat (21) sous-jacent et pour définir au moins un des éléments (30, 32, 34) dans au moins une portion non gravée (24) de ladite couche,
et une étape ultérieure d'oxydation thermique (E240) du substrat (21), incluant les portions non gravées et les portions gravées lors de la dernière étape de formation, pour former, sur une portion nue de celui-ci, une couche (28) d'oxyde sur une épaisseur égale à la troisième épaisseur (E4), de sorte à former, uniquement par lesdites oxydations thermiques successives, consommatrices du substrat, les au moins deux éléments dont les parois définissant le volume de la structure fixe.

2. Procédé selon la revendication 1, dans lequel ladite première étape de formation (E210) forme une couche d'oxyde (23) sur une première épaisseur E1 et la ou les étapes ultérieures de formation (E220, E230) forment chacune une couche d'oxyde (26, 27) qui, sur une portion (25) mise à nu du substrat (21), présente d'autres premières épaisseurs Ei, où i identifie une étape ultérieure de formation, de telle sorte que les parois (30) définissant ledit volume (10) ont, après les étapes ultérieures de formation (E220, E230), une épaisseur(E1"') d'oxyde strictement comprise entre E1 et E1+ΣEi.

3. Procédé selon la revendication 1 ou 2, dans lequel le nombre d'étapes de formation est égal au nombre de dimensions verticales différentes associées aux éléments à former.

4. Procédé selon l'une des revendications 1 à 3, dans lequel, lors d'une étape ultérieure de formation (E220), une portion non gravée (24) au niveau d'une portion entièrement gravée (25) lors de l'étape de gravure (E218) immédiatement précédente forme au moins une butée (32).

5. Procédé selon l'une des revendications 1 à 3, dans lequel, lors d'une étape ultérieure de formation (E230), une portion non gravée (24) au niveau d'une portion entièrement gravée (25) lors de l'étape de gravure (E228) immédiatement précédente forme au moins un plot (34) pour recevoir un contact électrique (42).

6. Procédé selon l'une des revendications précédentes, dans lequel la structure fixe (20) est une structure fixe de microsystème électromécanique (1) qui définit un volume (10) apte à recevoir un élément mécaniquement mobile (90) du microsystème électromécanique.

7. Procédé selon l'une des revendications précédentes, dans lequel ladite étape préalable de détermination comprend l'évaluation desdites épaisseurs par simulation informatique.

8. Procédé de fabrication d'un microsystème électromécanique (1) comprenant les étapes suivantes :
- fabriquer (E100) une structure fixe (20) de microsystème électromécanique (1) selon l'une des revendications précédentes,
- former (E120, E340, E350) un élément mécaniquement mobile (90) suspendu à ladite structure fixe (20) et configuré pour se déplacer dans le volume (10) défini par ladite structure fixe (20) ainsi fabriquée.

9. Procédé selon la revendication précédente, dans lequel ledit microsystème électromécanique est un commutateur.

## Patentansprüche

1. Verfahren zur Herstellung einer festen Struktur (20), die wenigstens zwei Elemente (30, 32, 34) aufweist, wovon ein Element Wände der festen Struktur bildet, die jeweils wenigstens eine unterschiedliche vertikale Abmessung (p, b, c) in einem durch die Wände der festen Struktur definierten Volumen (10) aufweisen,
**dadurch gekennzeichnet, dass** es umfasst:
einen vorherigen Schritt zur Bestimmung (E000) von wenigstens drei Dicken in Abhängigkeit der wenigstens zwei vertikalen Abmessungen, die den wenigstens zwei Elementen, darunter die Wände, zugeordnet sind;
wenigstens zwei aufeinanderfolgende Schritte zur Bildung (E210, E220, E230) der wenigstens zwei Elemente (30, 32, 34), darunter die Wände, auf einem Substrat (21), von dem wenigstens eine Fläche aus thermisch oxidierbarem Material besteht, wobei jeder Bildungsschritt, von denen der erste die Wände bildet, (E210, E220, E230) umfasst:
- einen Schritt zur thermischen Oxidation (E214, E224, E234) des Substrats (21) einschließlich der nicht geätzten Abschnitte und der während des vorhergehenden Bildungsschrittes geätzten Abschnitte, um auf einem blanken Abschnitt dessen eine Oxidschicht (23, 26, 27) über eine Dicke, die gleich einer (E1, E2, E3) der Dicken ist, zu bilden, und
- einen Schritt zum Ätzen (E216, E226, E236), das in Bezug auf das thermisch oxidierbare Material selektiv ist und die während des vorhergehenden Bildungsschrittes nicht geätzten Abschnitte nicht geätzt belässt, der so gebildeten Oxidschicht (23, 26, 27), um das Volumen (10) in einem geätzten Abschnitt (25) der Schicht durch Freilegen des darunter liegenden Substrats (21) zu definieren und um wenigstens eines der Elemente (30, 32, 34) in wenigstens einem nicht geätzten Abschnitt (24) der Schicht zu definieren,
sowie einen nachträglichen Schritt zur thermischen Oxidation (E240) des Substrats (21), einschließlich der nicht geätzten Abschnitte und der während des letzten Bildungsschrittes geätzten Abschnitte, um auf einem blanken Abschnitt dessen eine Oxidschicht (28) über eine Dicke, die gleich der dritten Dicke (E4) ist, zu bilden, um einzig und allein durch die aufeinanderfolgenden, das Substrat verbrauchenden thermischen Oxidationen die wenigstens zwei Elemente, darunter die das Volumen der festen Struktur definierenden Wände, zu bilden.

2. Verfahren nach Anspruch 1, wobei der erste Bildungsschritt (E210) eine Oxidschicht (23) über eine erste Dicke E1 bildet und der oder die nachträglichen Bildungsschritte (E220, E230) jeweils eine Oxidschicht (26, 27) bilden, die auf einem freigelegten Abschnitt (25) des Substrats (21) weitere erste Dicken Ei, wobei i einen nachträglichen Bildungsschritt kennzeichnet, aufweist, derart, dass die das Volumen (10) definierenden Wände (30) nach den nachträglichen Bildungsschritten (E220, E230) eine streng zwischen E1 und E1 + ΣEi liegende Oxiddicke (E1"') aufweisen.

3. Verfahren nach Anspruch 1 oder 2, wobei die Anzahl der Bildungsschritte gleich der Anzahl von den zu bildenden Elementen zugeordneten unterschiedlichen vertikalen Abmessungen ist.

4. Verfahren nach einem der Ansprüche 1 bis 3, wobei bei einem nachträglichen Bildungsschritt (E220) ein nicht geätzter Abschnitt (24) im Bereich eines während des unmittelbar vorhergehenden Ätzschrittes (E218) vollständig geätzten Abschnittes (25) wenigstens einen Anschlag (32) bildet.

5. Verfahren nach einem der Ansprüche 1 bis 3, wobei bei einem nachträglichen Bildungsschritt (E230) ein nicht geätzter Abschnitt (24) im Bereich eines während des unmittelbar vorhergehenden Ätzschrittes (E228) vollständig geätzten Abschnittes (25) wenigstens einen Pin (34) zur Aufnahme eines elektrischen Kontakts (42) bildet.

6. Verfahren nach einem der vorhergehenden Ansprüche, wobei die feste Struktur (20) eine feste Struktur eines elektromechanischen Mikrosystems (1) ist, die ein Volumen (10) definiert, welches geeignet ist, ein mechanisch bewegliches Element (90) des elektromechanischen Mikrosystems aufzunehmen.

7. Verfahren nach einem der vorhergehenden Ansprüche, wobei der vorherige Bestimmungsschritt die Abschätzung der Dicken durch Computersimulation umfasst.

8. Verfahren zur Herstellung eines elektromechanischen Mikrosystems (1), umfassend die folgenden Schritte:
- Herstellen (E100) einer festen Struktur (20) eines elektromechanischen Mikrosystems (1) nach einem der vorhergehenden Ansprüche,
- Bilden (E 120, E340, E350) eines mechanisch beweglichen Elements (90), das an der festen Struktur (20) aufgehängt und dazu ausgebildet ist, sich in dem durch die so hergestellte feste Struktur (20) definierten Volumen (10) zu bewegen.

9. Verfahren nach dem vorhergehenden Anspruch, wobei das elektromechanische Mikrosystem ein Schalter ist.

## Claims

1. A method for fabricating a fixed structure (20) having at least two elements (30, 32, 34), one element of which forms walls of the fixed structure, respectively having at least one distinct vertical dimension (p, b, c) in a volume (10) defined by said walls of said fixed structure, **characterized in that** it comprises:
a prior step of determining (E000) at least three thicknesses depending on the at least two vertical dimensions associated with said at least two elements comprising the walls;
at least two successive steps of forming (E210, E220, E230), on a substrate (21) of which at least one surface is of thermally oxidizable material, the at least two elements (30, 32, 34) comprising the walls, each forming step (E210, E220, E230) the first of which forms the walls comprising:
- a step of thermal oxidation (E214, E224, E234) of the substrate (21) including the portions unetched and the portions etched during the preceding forming step, to form, on a bare portion thereof, an oxide layer (23, 26, 27) to a thickness equal to one (E1, E2, E3) of the thicknesses, and
- a step of etching (E216, E226, E236), which is selective relative to said thermally oxidizable material and keeping unetched the portions unetched during the preceding forming step, of the oxide layer (23, 26, 27) so formed to define said volume (10) in an etched portion (25) of said layer by baring the underlying substrate (21) and to define at least one of the elements (30, 32, 34) in at least one unetched portion (24) of said layer,
and a later step of thermal oxidation (E240) of the substrate (21), including the portions unetched and the portions etched during the last forming step to form, on a bare portion thereof, an oxide layer (28) to a thickness equal to the third thickness (E4), so as to form, solely by said successive thermal oxidations, which consume the substrate, the at least two elements the walls of which define the volume of the fixed structure.

2. A method according to claim 1, wherein said first forming step (E210) forms an oxide layer (23) to a first thickness E1 and the later forming step or steps (E220, E230) each form an oxide layer (26, 27) which, over a bared portion (25) of the substrate (21), has other first thicknesses Ei, where i identifies a later forming step, such that the walls (30) defining said volume (10) have, after the later forming steps (E220, E230), an oxide thickness (E1"') strictly comprised between E1 and E1+ΣEi.

3. A method according to claim 1 or 2, wherein the number of forming steps is equal to the number of different vertical dimensions associated with the elements to form.

4. A method according to one of claims 1 to 3, wherein, at a later forming step (E220), an unetched portion (24) at the location of a portion fully etched (25) at the immediately preceding etching step (E218) forms at least one abutment (32).

5. A method according to one of claims 1 to 3, wherein, at a later forming step (E230), an unetched portion (24) at the location of a portion fully etched (25) at the immediately preceding etching step (E228) forms at least one projection (34) to receive an electrical contact (42).

6. A method according to one of the preceding claims, wherein the fixed structure (20) is a micro electro-mechanical system fixed structure (1) which defines a volume (10) adapted to receive a mechanically movable element (90) of the micro electro-mechanical system.

7. A method according to one of the preceding claims, wherein said prior determining step comprises evaluating said thicknesses by computer simulation.

8. A method of fabricating a micro electro-mechanical system (1) comprising the following steps:
- fabricating (E100) a micro electro-mechanical system (1) fixed structure (20) according to one of the preceding claims,
- forming (E120, E340, E350) a mechanically movable element (90) suspended from said fixed structure (20) and configured to move in the volume (10) defined by said fixed structure (20) so fabricated.

9. A method according to the preceding claim, wherein said micro electro-mechanical system is a switch.
